# EUROPEAN PATENT APPLICATION

(11) **EP 2 424 335 A1**
(43) Date of publication of application: **29.02.2012**
(21) Application number: 11179511.8
(22) Date of filing: 31.08.2011
(51) Int. Cl.: H05B 33/24, H01L 51/52, H05B 33/22

(54) **Organic electroluminescent light emitting device**

(30) Priority: 31.08.2010 JP 2010194399
(71) Applicant: Nitto Denko Corporation, Ibaraki-shi, Osaka (JP)
(72) Inventor: Nakai, Takahiro, Osaka (JP)
(74) Representative: Siegert, Georg

(57) **Abstract**

The present invention relates to an organic electroluminescent light emitting device including: a substrate; and a plurality of organic electroluminescent elements being arranged and mounted on the substrate and each having a transparent electrode, a reflective electrode and an organic light emitting layer interposed between the transparent electrode and the reflective electrode, with surface emission of the organic light emitting layer being allowed to outgo toward a top side of the organic electroluminescent light emitting device through the transparent electrode, in which the substrate has a ridge between two adjacent elements of the organic electroluminescent elements, and the ridge has reflecting surfaces facing side end faces of the two adjacent elements for reflecting side lights outgoing from the side end faces of the two adjacent elements toward the top side of the organic electroluminescent light emitting device.

## Description

### FIELD OF THE INVENTION

The present invention relates to an organic electroluminescent light emitting device including a substrate having a plurality of organic electroluminescent elements arranged and mounted thereon.

### BACKGROUND OF THE INVENTION

In electroluminescent elements in which a light emitting layer is provided between electrodes to electrically obtain emission, not only utilization as a light emitting display device but also utilization as a light source of a light emitting device of every kind, such as plane illumination, a light source for optical fiber, a backlight for liquid crystal display and a backlight for liquid crystal projector, is advancing. In particular, organic electroluminescent (hereinafter referred to as "organic EL") elements using an organic thin film for the light emitting layer are watched from the standpoints of luminous efficiency, low-voltage driving, lightweight and flexibility, and utilization for the foregoing light emitting devices or light emitting display devices and so on are also rapidly expanding.

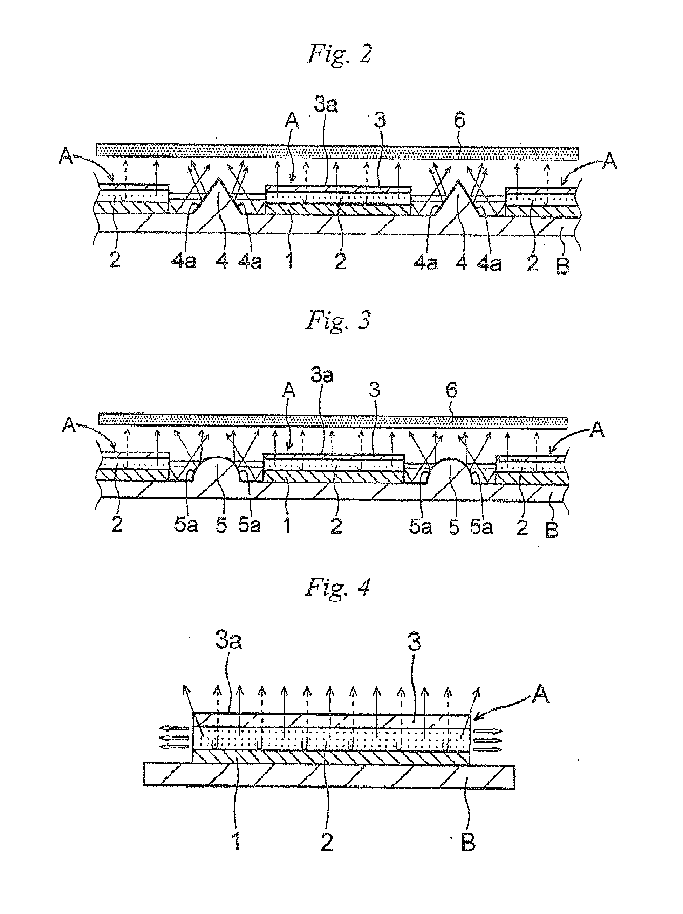

A diagrammatic configuration of a light emitting device using the foregoing organic EL element is shown in Fig. 4. Fig. 4 enlargedly shows an element portion of an organic EL light emitting device of a top emission type (specification) of extracting emission from an upper part of a substrate. Incidentally, illustration of a conductive paste, a bonding wire, an encapsulation resin and the like, which are used for mounting (electric connection) of the element, is omitted.

As shown in Fig. 4, each of organic EL elements A used in an organic EL light emitting device is configured to include a transparent electrode (translucent conductive layer) 3, a reflective electrode (light reflective conductive layer) 1 and an organic light emitting layer (organic semiconductor thin film) 2 interposed between these electrodes, and a surface on the side of the transparent electrode 3 (top surface shown in Fig. 4) is a light emitting surface 3a for extracting light, Also, in the whole of the light emitting device, a large number of the organic EL devices A are used, and the respective organic EL elements A are arranged and disposed lengthwise and breadthwise on a substrate B in a state where the light emitting surface 3a is faced upward, and these are electrically connected (mounted) (see Patent Documents 1 to 3).

As shown in Fig. 4, in the case of allowing each of the organic EL elements A of the light emitting device to turn on the electricity, light is emitted from the organic light emitting layer 2 of each of the elements A toward the entire surroundings (360°) of this organic light emitting layer 2. Then, light (top emission; expressed by solid line arrows in Fig. 4) emitted upward from a boundary (top surface) on the side of the transparent electrode 3 of the organic light emitting layer 2 passes through the transparent electrode 3 as it is and is allowed to outgo from the light emitting surface 3a. Also, light (bottom emission; expressed by dotted line arrows in Fig. 4) emitted from the organic light emitting layer 2 toward the reflective electrode 1 on the opposite side (lower side) is reflected by this reflective electrode 1 and passes upward through the organic light emitting layer 2, and similar to the foregoing top emission, the light is then allowed to outgo from the light emitting surface 3a of the organic EL element A.

In the organic EL element having such a configuration, when light extraction efficiency from the organic light emitting layer to the outside is enhanced, the necessary quantity of light is obtained at a smaller consumed electric power (voltage), so that it becomes possible to realize energy conservation and long life of the element. For that reason there have been made various studies for enhancing the light extraction efficiency of this organic EL device in the vertical (thickness) direction.

For example, there are proposed one in which a transparent base material having an irregular structure is adhered to the outside of a light emitting surface (Patent Document 4); and one in which a diffraction grating is formed within an organic EL element (Patent Document 5). Also, there are proposed one in which the side of a light extracting surface is formed so as to have a lens structure (Patent Document 6); and one in which the opposite side of an organic EL element is formed so as to have a stereostructure or formed with an inclined face (Patent Document 7).

- Patent Document 1:: JP-A-2005-327535
- Patent Document 2:: JP-A-2005-317254
- Patent Document 3:: JP-A-2004-335183
- Patient Document 4:: JP-A-9-63767
- Patent Document 5:: JP-A-11-283751
- Patent Document 6:: JP-A-9-171892
- Patent Document 7:: JP-A-11-214163

### SUMMARY OF THE INVENTION

Incidentally, in light emitting devices using the foregoing organic EL elements, it is known that a considerable amount of light (side light; expressed by arrow outlines witch a blank inside) is also allowed to outgo from a side end face of the element as shown in Fig. 4. However, it is the present situation that the light having leaked out from the side end face of this element reflects diffusely in an encapsulation resin or the like (not shown) filled in the surroundings of the organic EL element, is enclosed therein and then disappears, so that it is not effectively utilized. Thus, there is room for improving this issue.

Under such circumstances, the invention has been made, and an object thereof is to provide an organic electroluminescent light emitting device capable of effectively utilizing side light of an organic electroluminescent element at low costs and having high light extraction efficiency from the element.

Namely, the present invention relates to the following items 1 to 5.
1. An organic electroluminescent light emitting device including: a substrate; and a plurality of organic electroluminescent elements being arranged and mounted on the substrate and each having a transparent electrode, a reflective electrode and an organic light emitting layer interposed between the transparent electrode and the reflective electrode, with surface emission of the organic light emitting layer being allowed to outgo toward a top side of the organic electroluminescent light emitting device through the transparent electrode,
   in which the substrate has a ridge between two adjacent elements of the Organic electroluminescent elements, and
   the ridge has reflecting surfaces facing side end faces of the two adjacent elements for reflecting side lights outgoing from the side end faces of the two adjacent elements toward the top side of the organic electroluminescent light emitting device.
2. The organic electroluminescent light emitting device according to item 1, in which the ridge has a triangular cross-sectional shape and the reflecting surfaces of the ridge are inclined reflecting surfaces.
3. The organic electroluminescent light emitting device according to item 1, in which the ridge has a. semicircular cross-sectional shape and the reflecting surfaces of the ridge are curved reflecting surfaces.
4. The organic electroluminescent light emitting device according to any one of items 1 to 3, in which each of the organic electroluminescent elements disposed on the substrate has a rectangular shape or oblong shape in a plan view, and a length of the respective long sides is two or more times a length of the respective short sides.
5. The organic electroluminescent light emitting device according to any one of items 1 to 4, in which the reflecting surfaces have a reflectivity of 50% or more for light having a wavelength ranging from 450 to 800 nm.

That is, in place of the method of changing the structure of the organic EL element per se, which is high in efficiency but simultaneously brings a significant increase in costs, as disclosed in the foregoing Patent Documents 4 to 7, the present inventor made extensive and intensive investigations on a method for enhancing the emission extraction efficiency of the organic EL element at low costs and considered whether or not this can be realized on the side of a substrate on which the element is mounted. Then, the present inventor paid attention to a space on the substrate, which is formed between the respective elements, and kept improving. As a result, it has been found that by forming, on a substrate between adjacent organic EL elements to each other, a ridge provided with reflecting surfaces capable of reflecting lights outgoing from the side end faces of the elements of the both sides toward to the top side of the organic electroluminescent light emitting device and utilising side lights of these elements, the light extraction efficiency from each of the elements can be enhanced while suppressing an increase in costs, leading to accomplishment of the invention.

In the organic EL light emitting device of the invention, the substrate has a ridge between two adjacent elements of the organic electroluminescent elements, and the ridge has reflecting surfaces facing side end faces of the two adjacent elements for reflecting side lights outgoing from the side end faces of the two adjacent elements toward the top side of the organic electroluminiscent light emitting device. For that reason, the side light reflected by these reflecting surfaces is emitted above the element together with surface emission (top emission), whereby the emission efficiency of the entire element is seemingly enhanced. As a result, according to this organic EL light emitting device, a light emitting device having high light extraction efficiency can be realized at low costs without causing a large increase in costs regarding change in configuration of the light emitting elements, or the like.

Furthermore, according to the organic EL light emitting device of the invention, as described above, the light extraction efficiency of each of the organic. EL elements is enhanced, and therefore, as compared with conventional light emitting devices having the same configuration, the same quantity of light (luminance) can be obtained at a smaller consumed electric power (voltage). For that reason, it becomes possible to realize energy conservation and long life of the light emitting device by low-voltage driving, Also, it is possible to exchange each of the organic EL elements with one with a smaller area in proportion to an enhancement of the light extraction efficiency. In that case, in addition to energy conservation of the light emitting device the same as that described above, manufacturing costs of a light emitting device can be reduced, and hence, such is advantageous.

Then, as for the organic EL light emitting device of the invention, one in which the ridge has a triangular cross-sectional shape and the reflecting surfaces of the ridge are inclined reflecting surfaces or one in which the ridge has a semicircular cross-sectional shape and the reflecting surfaces of the ridge are curved reflecting surfaces, can utilize a space (space on the substrate) between the adjacent organic EL elements to each other without wastefulness and efficiently reflect the side lights of the elements.

Also, as for the organic EL light emitting device of the invention, one in which each of the organic electroluminescent elements disposed on the substrate has a rectangular shape or oblong shape in a plan view, and a length of the respective long sides is two or more times a length of the respective short sides is long in a length, of the periphery (whole circumference) of each of the organic EL elements as compared with conventional organic EL elements in which an area (projected area) of the top surface of the element is the same, and the plane (top surface) has a square shape or circular shape or the like. For that reason, a length of the circumferential direction of the end face of each of the organic EL elements to be mounted on the substrate becomes long, and in its turn, an area of the side end face from which the side light is allowed to outgo becomes wide. According to this, in the foregoing organic EL elements in which the length of the long side is two or more times the length of the short side, the quantity of light of top emission and bottom emission to be allowed to outgo toward the top surface direction is not different from that of the foregoing organic EL elements having a square shape or circular shape or the like, and the quantity of light rather increases in proportion to the quality of light of the side light which is allowed to outgo from the side part of each of the elements. Accordingly, as for the light emitting device using the foregoing organic EL elements, in view of the fact that the side light from each of the elements increases, the light extraction efficiency is more enhanced.

Then, as for the organic EL light emitting device having a reflectivity of the reflecting surface of 50% or more for light having a wavelength ranging from 450 to 800 nm, the side light having the foregoing wavelength orange emitted from the organic EL element is reflected with high efficiency, and the light extraction efficiency is still more enhanced.

### BRIEF DESCRIPTION OF THE DRAWINGS

Fig. 1 is a view of a substrate of a light emitting device according to an embodiment of the invention as seen from the light emitting Side,
Fig. 2 is a sectional view of a light emitting device according to an embodiment of the invention and is a view corresponding to an X-X line section of Fig. 1.
Fig, 3 is a sectional view of a modification of a light emitting device according to an embodiment of the invention.
Fig. 4 is a sectional view showing a configuration of a conventional light emitting device using an organic EL element,

### DETAILED DESCRIPTION OF THE INVENTION

Next, modes for carrying out the invention are described in detail by referring to the accompanying drawings.

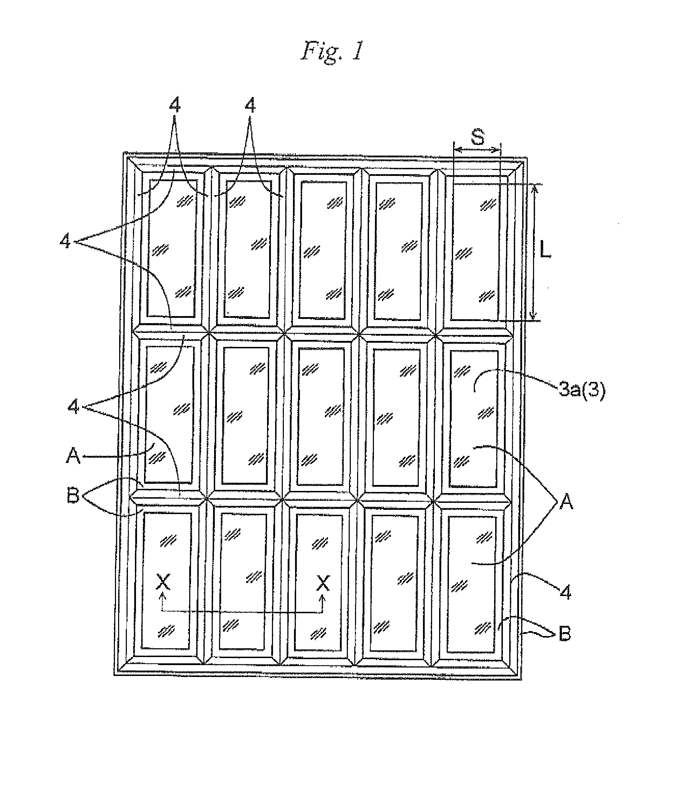

Fig. 1 is a view of a substrate of a light emitting device according to an embodiment of the invention as seen from the light emitting side (upper side); and Fig. 2 is an explanatory view showing a configuration of this light emitting device and is a view corresponding to an X-X line section of Fig. 1. Incidentally, in Fig, 1, in order to make it easy to see a structure on a substrate B and an organic EL device A, illustration of an optical pressure-sensitive adhesive (encapsulation resin) to be filled on this substrate B and a light diffusing plate are omitted. Also, in Fig. 2, in order to make it easy to understand light having outgone from the organic EL device A, illustration of an optical pressure-sensitive adhesive to be filled between the substrate B and a light diffusing plate 6 is omitted.

As shown in Fig. 1, the light emitting device according to the present embodiment is a top emission type organic EL light emitting device in which a plurality of organic EL elements A are arranged and mounted on a substrate B lengthwise and breadthwise (in this exemplary embodiment, three rows in the lengthwise direction and five rows in the breadthwise direction), and each of the elements A emits light toward the front side of the paper of Fig. 1 (above the paper, namely, opposite side to the substrate B).

As shown in Fig. 1 and Fig. 2 that is a sectional view of Fig. 1, in the foregoing light emitting device, in a prescribed portion of the substrate B between the organic EL device A and the organic EL device A adjacent thereto, a ridge 4 having reflecting surfaces 4a and 4a for reflecting side lights outgoing from the side end faces of the respective elements A of the both sides above the substrate B (toward the top side of the device) is formed. This is a characteristic feature of the organic EL light emitting device in the present embodiment.

The structure of the light emitting device is described in more detail. The substrate B in which the organic EL elements A are mounted thereon has a substantially planar material including a metal, a resin, a glass or the like, and as shown in Fig. 1, the forgoing ridge 4 is formed in the surroundings at a position in which each of the organic EL elements A is prearranged to be mounted. As shown in Fig. 2, the ridge 4 is formed so as to have a triangular cross-sectional shape, has inclined reflecting surfaces 4a and 4a so as to face the side end surfaces of the organic EL elements A and is provided integrally with the substrate B.

Also, a reflective (glossy) coating film made of aluminum (An), silver (Ag) or the like is formed on the surface of each of the reflecting surfaces 4a and 4a of the ridge 4 and the surface of the substrate B continuing thereon by sputtering, vacuum vapor deposition or the like, and a reflectivity of each of these surfaces is preferably set to 50% or more, and preferably 80% or more for light having a wavelength ranging from 450 to 800 nm.

Examples of a material constituting the substrate B include not only metals such as aluminum (Al), copper (Cu) and stainless steel (SUS), but also a glass as well as resins such as polyethylene (PE), polypropylene (PP), polystyrene (PS), polycarbonate (PC), polyimide (PI), methacrylate resin (PMMA), polyethylene terephthalate (PET), polyethylene naphthalate (PEN) and cycloolefin resin (COP). In the case where the substrate B and the ridge 4 are formed using a material having a reflectivity of 50% or more for light having a wavelength ranging from 450 to 800 nm, or a white resin or fluorocarbon resin with light reflecting properties, a reflective coating film may not be provided on the surface of the reflecting surface 4a, or the like,

As for a method for forming the ridge 4, not only the ridge 4 may be provided integrally with the substrate B by injection molding, imprinting or the like, but also the ridge 4 may be formed as a separate body on the substrate B by printing, inkjetting, photolithography or the like. Also, in addition to the triangular shape shown in Fig. 2, the cross-sectional shape of the foregoing ridge may be any shape as long as it has reflecting surfaces capable of reflecting side light outgoing from the side end face of the element A above the substrate B (toward the top side of the device), such as a ridge 5 (reflecting surface 5a) having a semicircular cross-sectional shape as shown in Fig. 3 that is a modification, a trapezoidal shape and a Gothic arc shape composed of a compound curved surface.

Incidentally, while illustration is omitted in Fig. 2, an optical pressure-sensitive adhesive (encapsulation resin) is filled between the light diffusing plate 6 disposed above the substrate B and each of the organic EL elements A, whereby surface emission and side light (reflected light by the ridge 4) having come out from each of the organic EL elements A are guided into the light diffusing plate 6. Then, these emissions are mixed by light scattering within the light diffusing plate 6 and emitted as substantially uniform light from the top surface of this light diffusing plate 6.

Also, as shown in Fig. 2, similar to the conventional technology the organic EL element A to be mounted on the substrate B is configured to include a transparent electrode (translucent conductive layer) 3, a reflective electrode (light reflective conductive layer) 1 and an organic light emitting layer (organic semiconductor thin film) 2 interposed between these electrodes. Then, a surface on the side of the transparent electrode 3 (top surface shown in Fig. 2) works as a light emitting surface 3a for extracting light, and as shown in Fig. 1, the organic EL elements A are each disposed at a prescribed position on the substrate B, the circumstance of which is surrounded by the ridges 4, in a state where the light emitting surface 3a is faced upward (top emission type), and these are electrically connected (mounted) to each other,

As for the organic EL elements A, as shown in Fig. 1, an external shape of the individual element A is preferably a rectangular shape or oblong shape in a plan view, and a length L of the respective long sides is preferably two or more times a length S of the respective short side. This is a measure for increasing the quantity of light of the side light which is allowed to outgo from the side face of each of the elements A, and according to this, a length of the periphery (whole circumference) of each of the organic EL elements A can be made long without changing an area (projected area) of the top surface of the element A. That is, since the area of the top surface of each of the organic EL elements A is expressed by "(length L of long side) × (length S of short side)", even when such a ratio is varied, the area does not change. However, since the length of the periphery is calculated by an expression of "{(length L of long side) × 2} + {(length S of short side) × 2}", when the ratio of the length L of the long side is increased, the length of the periphery as a total sum (namely "length of the end face of each element A in a circumferential direction") becomes long. In this way, in view of the fact that the light emitting device according to the present embodiment employs a configuration in which the side light from each of the organic EL elements A is increased, coupled with the configuration of the ridge 4 of the substrate B, the light extraction efficiency from each of the elements A is more enhanced.

Incidentally, it is desirable that in the foregoing organic EL element A having a rectangular shape or oblong shape, the length L of the long side is at least two or more times the length S of the short side, preferably five or more times the length S of the short side, and more preferably ten or more times the length S of the short side. As described previously, the reason why it is desirable that the ratio of the length L of the long side to the length S of the short side is large resides in the matter that the light extraction efficiency is more enhanced.

According to the foregoing configuration, in the organic EL light emitting device according to the present embodiment, the side light of each of the elements A reflected by the reflecting surface 4a of the ridge 4 is emitted above the element A together with the surface emission of the light emitting surface 3a, whereby the light extraction efficiency (apparent luminous efficiency) is enhanced. For that reason, this organic EL light emitting device is able to achieve a significant enhancement of the light extraction efficiency with a small increase in costs.

Also, as compared with a conventional light emitting device having the same configuration, the organic EL light emitting device according to the present embodiment is able to obtain the same quantity of light (luminance) at a smaller consumed electric power (voltage), For that reason, it becomes possible to realize energy conservation and long life of the light emitting device by low-voltage driving.

### EXAMPLES

Next, Example is described along with Comparative Examples. However, it should not be construed that the invention is limited to the following Examples.

In the present Examples, a light emitting device in which similar to the foregoing embodiment, organic EL elements having an oblong shape (20 mm × 30 mm in square) were mounted on a substrate having a ridge for reflecting side light formed between the respective elements (Example 1); a light emitting device in which organic EL elements having the foregoing oblong shape were mounted on a ridge-free flat substrate (Comparative Example 1); and a light emitting device in which large-sized organic EL elements of 90 mm × 80 mm in square were mounted on a ridge-free flat substrate (Comparative Example 2) were fabricated, and a "front luminous flux (accumulated luminance) per light emitting area" thereof was compared.

### (Example 1)

A substrate and organic EL elements were prepared, and the respective elements were mounted on the substrate,

### [Substrate]

Glass-made substrate: 100 mm × 100 mm in square, in which the top surface of the substrate is fractionated by the following ridges into cells of three rows in width and two rows in length.

Ridge for reflecting side light: Formed with a pitch of 20 mm in width and a pitch of 30 mm in length (see Fig. 1) on the top surface of the substrate. A cross-section of each ridge has a triangular shape (height of ridge: 1 mm, see Fig. 2).

### [Organic EL element]

Light emitting area on the top surface of element (light emitting surface 3a): 10 mm × 20 mm in square (200 mm²)
Number of used elements: Six (total light emitting area: 1,200 mm²)
Incidentally, the organic EL elements are previously fixed onto a base (about 16 mm × about 26 mm) which is fitted within the pitch of the cell by the ridges.

### [Fabrication, of light emitting devices]

First of all, a reflective coating film (film thickness: 100 nm) made of aluminum (Al) was subjected to film formation on the foregoing (ridge-provided) glass substrate by the RF magnetron sputtering method. The film formation condition was as follows. Inputted electric power: RF 200 W, reaction gas pressure: 0.5 Pa, flow rate of inert gas (Ar): 1.69 × 10⁻³ Pa·m³/sec, film formation rate: 20 nm/min.

Subsequently, the foregoing glass substrate having a reflective coating film formed thereon was used, and the organic EL elements were each placed in the center of each division surrounded by the ridges of the top surface thereof, followed by electrically connecting and mounting by bonding or the like. Thereafter, an upper part of each of the organic EL elements was filled with an optical pressure-sensitive adhesive, to which was then adhered a light diffusing plate, thereby obtaining an organic EL light emitting device of Example 1.

### (Comparative Example 1)

An organic EL light emitting device of Comparative Example 1 was fabricated in the same manner as in the foregoing Example 1, except for using a flat glass substrate having no ridge on the surface thereof as the glass substrate.

### (Comparative Example 2)

The same flat glass substrate having no ridge on the surface thereof as that in Comparative Example 1 was used as the glass substrate, and large-sized organic EL elements having a light emitting area on the top surface of the element of 90 mm × 80 mm in square were mounted on the glass surface as it was without forming a reflective coating film on the surface thereof. Thereafter, an upper part of each of the organic EL elements was filled with an optical pressure-sensitive adhesive, to which was then adhered the same light diffusing plate as that in Example 1, thereby obtaining an organic EL light emitting device of Comparative Example 2.

### (Measurement of front luminous flux (luminance))

The measurement of luminance was carried out by adjusting an electric power such that each of the organic EL elements used in Example 1 and Comparative Examples 1 and 2 had a luminance of 1,000 cd/m². Then, an area of 60 mm × 60 mm of the center of the glass substrate was fractionated into 10 mm × 10 mm, respectively, and an accumulation of front luminance in the center of each of the divisions (36 places in total) was defined as a front luminous of the organic EL light emitting device. Incidentally, the front luminous flux is expressed in terms of a relative amount (a.u.) while defining a measures value of Example 1 as a blank (1).

The measurement results are shown in the following Table 1.

**Table I**

| | Front luminous flux (a.u.) | Light emitting area (mm²) | (Front luminous flux)/(Light emitting area) (a.u.) |
|---|---|---|---|
| Example 1 | 1 | 1,200 | 1 |
| Comparative Example 1 | 0.41 | 1,200 | 0.41 |
| Comparative Example 2 | 1.22 | 3,600 | 0.40 |

As is noted from a comparison between Example 1 and Comparative Example 1 in Table 1, the organic EL light emitting device using a ridge-tree substrate is low in the front luminous flux and also small in the front luminous flux per light emitting arena, Also, in the organic EL light emitting device of Comparative Example 2 undergoing overall emission, though the front luminous flux is high, the light emitting area is large so that the front luminous flux per light emitting area becomes inversely small.

It may be considered that the reason why the front luminous flux per light emitting area of each of Comparative Examples 1 and 2 is small is derived from the matter that the side light of the organic EL element cannot be effectively utilized. On the other hand, it may be said that in the organic EL light emitting device of Example 1, the front luminous flux per consumed electric power is relatively large, and the light extraction efficiency is high.

While the invention has been described in detail with reference to specific embodiments thereof, it will be apparent to one skilled in the art that various changes and modifications can be made therein without departing from the spirit and scope thereof.
Incidentally, the present application is based on Japanese Patent Application No. 2010-194399 filed on August 31, 2010, and the contents are incorporated herein by reference.
All references cited herein are incorporated by reference herein in their entirety. Also, all the references cited herein are incorporated as a whole.

The organic electroluminescent light emitting device of the invention is suitable for a light source of a light emitting device of every kind, such as plane illumination, a light source for optical fiber, a backlight for liquid crystal display and a backlight for liquid crystal projector, and also for a light emitting device required to have high light emitting efficiency, such as a light emitting display device.

### Description of Reference Numerals and Signs

1: Reflective electrode
2: Organic light emitting layer
3: Transparent electrode
4: Ridge
4a: Reflecting surface
A: Organic El device
B: Substrate

## Claims

1. An organic electroluminescent light emitting device comprising: a substrate; and a plurality of organic electroluminescent elements being arranged and mounted on the substrate and each having a transparent electrode, a reflective electrode and an organic light emitting layer interposed between the transparent electrode and the reflective electrode with surface emission of the organic light emitting layer being allowed to outgo toward a top side of the organic electroluminescent light emitting device through the transparent electrode,
wherein the substrate has a ridge between two adjacent elements of the organic electroluminescent elements, and
the ridge has reflecting surfaces facing side end faces of the two adjacent elements for reflecting side lights outgoing from the side end faces of the two adjacent elements toward the top side of the organic electroluminescent light emitting device,

2. The organic electroluminescent light emitting device according to claim 1, wherein the ridge has a triangular cross-sectional shape and the reflecting surfaces of the ridge are inclined reflecting surfaces.

3. The organic electroluminescent light emitting device according to claim 1, wherein the ridge has a semicircular cross-sectional shape and the reflecting surfaces of the ridge are curved reflecting surfaces.

4. The organic electroluminescent light emitting device according to any one of claims 1 to 3, wherein each of the organic electroluminescent elements disposed on the substrate has a rectangular shape or oblong shape in a plan view, and a length of the respective long sides is two or more times a length of the respective short sides.

5. The organic electroluminescent light emitting device according to any one of claims 1 to 4, wherein the reflecting surfaces have a reflectivity of 50% or more for light having a wavelength ranging from 450 to 800 nm.
